# EUROPEAN PATENT APPLICATION

(11) **EP 4 550 765 A1**
(43) Date of publication of application: **07.05.2025**
(21) Application number: 23905611.2
(22) Date of filing: 27.11.2023
(51) Int. Cl.: H04M 1/02, F16C 11/04

(54) **FOLDABLE ELECTRONIC DEVICE AND HINGE**

(30) Priority: 19.12.2022 CN 202211629602
(71) Applicant: Huawei Technologies Co., Ltd., Shenzhen, Guangdong 518129 (CN)
(72) Inventor: LIAO, Changliang, Shenzhen, Guangdong 518129 (CN); XU, Zhengyi, Shenzhen, Guangdong 518129 (CN); WANG, Gangchao, Shenzhen, Guangdong 518129 (CN)
(74) Representative: Epping - Hermann - Fischer
(86) International application number: PCT/CN2023/134281
(87) International publication number: WO 2024/131443

(57) **Abstract**

A foldable electronic device and a hinge are provided. The hinge (10) includes a main shaft (11), a first foldable assembly (12), and a second foldable assembly (13). The first foldable assembly (12) includes a first rotating member (121), a first body (122), and a first connecting rod (123), where the first rotating member (121) is rotatably connected to the main shaft (11), and is slidably connected to the first body (122). The second foldable assembly (13) includes a second rotating member (131), a second body (132), and a second connecting rod (133), where the second rotating member (131) is rotatably connected to the main shaft (11), and is slidably connected to the second body (132), one end of the first connecting rod (123) is rotatably connected to the first body (122), the other end of the first connecting rod (123) is rotatably connected to the second rotating member (131), one end of the second connecting rod (133) is rotatably connected to the second body (132), and the other end of the second connecting rod (133) is rotatably connected to the first rotating member (121). The hinge has a simple structure, and uses a small quantity of parts. When the hinge is folded or unfolded, a length may change, and an action force on a flexible display can be avoided.

## Description

### CROSS-REFERENCE TO RELATED APPLICATIONS

This application claims priority to Chinese Patent Application No. 202211629602.4, filed with the China National Intellectual Property Administration on December 19, 2022 and entitled "FOLDABLE ELECTRONIC DEVICE AND HINGE", which is incorporated herein by reference in its entirety.

### TECHNICAL FIELD

This application relates to the field of electronic device technologies, and in particular, to a foldable electronic device and a hinge.

### BACKGROUND

Currently, a foldable display is widely used in a foldable electronic device. The foldable display is mainly implemented by combining a flexible display (organic light-emitting diode, OLED) and a hinge. Because the flexible display is a fragile component, large pressure or a large pulling force cannot be borne in a folding process. Otherwise, a bump, a crease, breakage, or the like may occur. At present, some manufacturers start to use a hinge with an adjustable length to prevent the flexible display from being squeezed in a folding process. However, an existing hinge has a complex structure, uses more parts, and has high manufacturing costs. In an assembling process, a complex assembly process, low assembly efficiency, and other problems also occur.

### SUMMARY

This application provides a foldable electronic device and a hinge that are simple in structure and can well support a flexible display.

According to a first aspect, this application provides a foldable electronic device, including a first housing, a second housing, a flexible display, and a hinge. The hinge includes a main shaft, and a first foldable assembly and a second foldable assembly that are symmetrically disposed with respect to the main shaft. The first foldable assembly and the second foldable assembly may rotate toward or away from each other, to implement a folding function of the hinge. Specifically, the first foldable assembly includes a first rotating member, a first body, and a first connecting rod. A first end of the first rotating member is rotatably connected to the main shaft, and a second end of the first rotating member is slidably connected to the first body. The second foldable assembly includes a second rotating member, a second body, and a second connecting rod. A first end of the second rotating member is rotatably connected to the main shaft, and a second end of the second rotating member is slidably connected to the second body. In addition, a first end of the first connecting rod is rotatably connected to the first body, and a second end of the first connecting rod is rotatably connected to the first end of the second rotating member. A first end of the second connecting rod is rotatably connected to the second body, and a second end of the second connecting rod is rotatably connected to the first end of the first rotating member. In addition, the first housing is fastened to the first body, and the second housing is fastened to the second body. A first part of the flexible display is fastened to the first housing, and a second part of the flexible display is fastened to the second housing.

The first body has a first support surface for supporting the flexible display, and the second body has a second support surface for supporting the flexible display. The first housing has a first mounting surface, the second housing has a second mounting surface, and a side that is of the flexible display and that is opposite to the display surface is fastened to the first mounting surface and the second mounting surface. When the hinge is in an unfolded state, the first mounting surface, the second mounting surface, the first support surface, and the second support surface are located on a same plane, adjacent edges of the first mounting surface and the first support surface are spliced with each other, and adjacent edges of the second mounting surface and the second support surface are spliced with each other. In an actual application, the first mounting surface, the second mounting surface, the first support surface, and the second support surface can provide good planar support for the flexible display. When the flexible display is touched or pressed, the first mounting surface, the second mounting surface, the first support surface, and the second support surface can effectively support the flexible display, so as to effectively prevent deformation of the flexible display, and effectively ensure use security of the flexible display and user experience. In addition, after the adjacent edges of the first mounting surface and the first support surface are spliced with each other, a case in which a support effect for the flexible display is reduced as there is an obvious gap between the first mounting surface and the first support surface can be effectively avoided. Correspondingly, after the adjacent edges of the second mounting surface and the second support surface are spliced with each other, a case in which a support effect for the flexible display is reduced as there is an obvious gap between the second mounting surface and the second support surface can be effectively avoided.

During use, an action force may be applied to the first housing and the second housing, so that the first housing and the second housing rotate relative to each other. The first housing may drive the first rotating member to move via the first body, and the second housing may drive the second rotating member to move via the second body, to implement a foldable connection between the first housing and the second housing. In processes of folding and unfolding the foldable electronic device, a connection length among the first housing, the hinge, and the second housing is extended or shortened, so that no extrusion pressure or stretching force is caused to the flexible display, and warpage, a crease, breakage, or the like of the flexible display can be avoided.

In an example, the main shaft may have a third support surface. When the hinge is in the unfolded state, the first mounting surface, the first support surface, the third support surface, the second support surface, and the second mounting surface are sequentially spliced to form a support surface for supporting the flexible display. That is, the first mounting surface, the second mounting surface, the first support surface, the second support surface, and the third support surface all can provide good planar support for the flexible display, so that use security of the flexible display and user experience can be effectively ensured.

During specific disposition, the flexible display may be fastened on the third support surface, to implement fastening between the flexible display and the third support surface. Alternatively, the flexible display may be lapped on the third support surface, that is, the flexible display and the third support surface may not in a fastening relationship.

In addition, the third support surface may be a flat surface, or may be a protruding arc-shaped surface, or a surface that is partially a flat surface and partially a curved surface.

For example, a side that is of the third support surface and that is adjacent to the first support surface is a first curved surface, a side that is of the third support surface and that is adjacent to the second support surface is a second curved surface, and a flat surface is disposed between the first curved surface and the second curved surface.

In an example, the first rotating member and the first connecting rod in the first foldable assembly may be both located on a side that is of the first body and that is opposite to the first support surface, to avoid a case in which a support effect of the first support surface on the flexible display is affected as the first rotating member and the first connecting rod protrude from the first support surface.

Correspondingly, the second rotating member and the second connecting rod in the second foldable assembly may be both located on a side that is of the second body and that is opposite to the second support surface, to avoid a case in which a support effect of the second support surface on the flexible display is affected as the second rotating member and the second connecting rod protrude from the second support surface.

In an example, the second end of the first connecting rod has a first pin hole, the first end of the second rotating member has a second pin hole, and the first connecting rod is rotatably connected to the second rotating member via a pin shaft that penetrates the first pin hole and the second pin hole. The second end of the second connecting rod has a third pin hole, the first end of the first rotating member has a fourth pin hole, and the second connecting rod is rotatably connected to the first rotating member via a pin shaft that penetrates the third pin hole and the fourth pin hole.

In an example, when the hinge changes from an unfolded state to a folded state, the first foldable assembly and the second foldable assembly rotate toward each other, the first rotating member and the first body rotate synchronously, and the second rotating member and the second body rotate synchronously. The first rotating member drives the first connecting rod to move, the first connecting rod drives the second body to approach the main shaft, the second rotating member drives the second connecting rod to move, and the second connecting rod drives the first body to approach the main shaft. This can shorten a length of the hinge. After the hinge is used in a foldable electronic device like a mobile phone, when the foldable electronic device is folded, an action force of stretching or compressing the flexible display can be avoided. Therefore, use security and reliability of the flexible display can be ensured.

In addition, when the foldable electronic device changes from the folded state to the unfolded state, the first foldable assembly and the second foldable assembly rotate away from each other, the first rotating member and the first body rotate synchronously, and the second rotating member and the second body rotate synchronously. The first rotating member drives the first connecting rod to move, the first connecting rod drives the second body to be away from the main shaft, the second rotating member drives the second connecting rod to move, and the second connecting rod drives the first body to be away from the main shaft. This can increase a length of the hinge. Alternatively, it may be understood that the foldable electronic device is in an outward-foldable form, and when the foldable electronic device is folded, the flexible display is located outside.

In the foldable electronic device provided in this application, a folding function of the hinge may be implemented via the main shaft, the first rotating member, the first body, the first connecting rod, the second rotating member, the second body, and the second connecting rod. In addition, in the processes of folding and unfolding the hinge, the length of the hinge may further change, to avoid an action force of stretching or compressing the flexible display. In addition, the hinge uses a small quantity of parts, and has a simple structure, so that manufacturing costs and assembling costs of the hinge can be effectively reduced.

In an example, the main shaft may include a first shaft body and a second shaft body. The first shaft body has a convex first cylindrical surface, and the second shaft body has a concave second cylindrical surface. The first cylindrical surface and the second cylindrical surface are disposed opposite to each other, so that the first shaft body and the second shaft body enclose first arc-shaped space. The first end of the first rotating member has a first arc-shaped arm, and the first arc-shaped arm is located in the first arc-shaped space between the first cylindrical surface and the second cylindrical surface. That is, the first end of the first rotating member is rotatably connected to the main shaft through the first arc-shaped arm and the first arc-shaped space.

In addition, during specific disposition, the first shaft body may further have a convex third cylindrical surface, and the second shaft body has a concave fourth cylindrical surface. The third cylindrical surface and the fourth cylindrical surface are disposed opposite to each other, so that the first shaft body and the second shaft body enclose second arc-shaped space. The first end of the second rotating member has a second arc-shaped arm, and the second arc-shaped arm is located in the second arc-shaped space between the third cylindrical surface and the fourth cylindrical surface. That is, the first end of the second rotating member is rotatably connected to the main shaft through the second arc-shaped arm and the second arc-shaped space.

In the processes of folding and unfolding the foldable electronic device, the first arc-shaped arm rotates along the first arc-shaped space, and the second arc-shaped arm rotates along the second arc-shaped space.

In addition, in the process of folding the foldable electronic device, the first arc-shaped arm rotates out of the first arc-shaped space, and the second arc-shaped arm rotates out of the second arc-shaped space. In the process of unfolding the foldable electronic device, the first arc-shaped arm rotates into the first arc-shaped space, and the second arc-shaped arm rotates into the second arc-shaped space.

The main shaft may include a first shaft body and a second shaft body. During manufacturing, the first shaft body and the second shaft body can be separately manufactured, so that manufacturing time can be shortened. During assembling, the first arc-shaped arm of the first rotating member may be disposed between the first cylindrical surface and the second cylindrical surface, and then the first shaft body and the second shaft body are fastened via a fastener like a screw, to implement assembling among the first rotating member, the second rotating member, the first shaft body, and the second shaft body.

During specific disposition, a surface that is of the first shaft body and that is away from the first cylindrical surface may be a flat surface. This helps implement flat disposition of the hinge.

**In** addition, a surface that is of the first shaft body and that is away from the third cylindrical surface may be a flat surface. This helps implement flat disposition of the hinge.

**In** an example, the first body may have a first sliding groove, the first rotating member may have a first sliding end, and the first sliding end may be slidably disposed in the first sliding groove, to implement a slidable connection between the first body and the first rotating member.

**In** addition, the second body may have a second sliding groove, the second rotating member may have a second sliding end, and the second sliding end may be slidably disposed in the second sliding groove, to implement a slidable connection between the second body and the second rotating member.

In the process of folding the foldable electronic device, the first sliding end slides into the first sliding groove, and the second sliding end slides into the second sliding groove. In the process of unfolding the foldable electronic device, the first sliding end slides out of the first sliding groove, and the second sliding end slides out of the second sliding groove.

In an example, the first foldable assembly may further include a first suspension assembly. The first rotating member may have a first mounting groove, and the first suspension assembly is disposed in the first mounting groove; and the first suspension assembly is in sliding contact with the first body, and is configured to provide a damping force when the first rotating member slides relative to the first body.

The first mounting groove configured to accommodate the first suspension assembly is provided in the first rotating member, so that compactness of the first foldable assembly can be improved, and a miniaturization design of the hinge can be implemented.

In addition, the second foldable assembly may further include a second suspension assembly. The second rotating member may have a second mounting groove, and the second suspension assembly is disposed in the second mounting groove; and the second suspension assembly is in sliding contact with the second body, and is configured to provide a damping force when the second rotating member slides relative to the second body.

The second mounting groove configured to accommodate the second suspension assembly is provided in the second rotating member, so that compactness of the second foldable assembly can be improved, and a miniaturization design of the hinge can be implemented.

It may be understood that, when the hinge is specifically disposed, the first suspension assembly or the second suspension assembly may be omitted, so that a quantity of used parts of the hinge can be reduced, and a suspension function can be implemented via the first suspension assembly or the second suspension assembly.

In an example, the foldable electronic device may further include a cover assembly, and the cover assembly includes a first plate body, a second plate body, and a third plate body. The first plate body is fastened to the first rotating member, the second plate body is fastened to the second rotating member, and the third plate body is fastened to the main shaft. The cover assembly can be disposed to effectively shield and protect a part like the first rotating member, the second rotating member, the first suspension assembly, or the second suspension assembly in the hinge for effectively shielding an external foreign matter. This can improve use safety of the hinge.

In an example, the hinge may further include a synchronization assembly, where the synchronization assembly is in transmission connection to the first body, the main shaft, and the second body for the first foldable assembly and the second foldable assembly to synchronously and reversely rotate.

During specific disposition, the synchronization assembly may include a first synchronization member and a second synchronization member. The first synchronization member is rotatably connected to the main shaft, and a rotation axis center of the first synchronization member coincides with a rotation axis center of the first rotating member; and the second synchronization member is rotatably connected to the main shaft, and a rotation axis center of the second synchronization member coincides with a rotation axis center of the second rotating member. The first synchronization member has a first tooth-shaped part and a first sliding part, and the second synchronization member has a second tooth-shaped part and a second sliding part. The first tooth-shaped part is engaged with the second tooth-shaped part, the first sliding part is slidably connected to the first body, and the second sliding part is slidably connected to the second body.

The synchronization assembly can be disposed to ensure smoothness of the first foldable assembly and the second foldable assembly during relative movement, so that use experience and reliability of the hinge can be improved.

During specific disposition, the hinge may include a first foldable assembly and a second foldable assembly that are correspondingly disposed. Alternatively, a plurality of first foldable assemblies and a plurality of second foldable assemblies that are disposed in a one-to-one correspondence may be included, to improve force-bearing performance of the hinge.

When the hinge includes a plurality of first foldable assemblies and a plurality of second foldable assemblies, the plurality of first foldable assemblies and the plurality of second foldable assemblies are disposed in a direction parallel to a length direction (an axial direction) of the main shaft. During specific setting, quantities of first foldable assemblies and second foldable assemblies may be properly set based on an actual requirement. This is not limited in this application.

According to a second aspect, this application further provides a hinge, which may be used in a foldable electronic device having a flexible display. The hinge may include a main shaft, and a first foldable assembly and a second foldable assembly that are symmetrically disposed with respect to the main shaft. The first foldable assembly and the second foldable assembly may rotate toward or away from each other, to implement a folding function of the hinge. Specifically, the first foldable assembly includes a first rotating member, a first body, and a first connecting rod. A first end of the first rotating member is rotatably connected to the main shaft, and a second end of the first rotating member is slidably connected to the first body. The second foldable assembly includes a second rotating member, a second body, and a second connecting rod. A first end of the second rotating member is rotatably connected to the main shaft, and a second end of the second rotating member is slidably connected to the second body. In addition, a first end of the first connecting rod is rotatably connected to the first body, and a second end of the first connecting rod is rotatably connected to the first end of the second rotating member. A first end of the second connecting rod is rotatably connected to the second body, and a second end of the second connecting rod is rotatably connected to the first end of the first rotating member. The first body has a first support surface for supporting the flexible display, the second body has a second support surface for supporting the flexible display, and when the hinge is in an unfolded state, the first support surface and the second support surface are located on a same plane. In an actual application, the first support surface and the second support surface can provide good planar support. When the flexible display is touched or pressed, the first support surface and the second support surface can effectively support the flexible display, so as to effectively prevent deformation of the flexible display, and effectively ensure use security of the flexible display and user experience.

In an example, the main shaft may have a third support surface for supporting the flexible display. When the hinge is in the unfolded state, the first support surface, the third support surface, and the second support surface are sequentially spliced to form a support surface for supporting the flexible display. That is, the first mounting surface, the second mounting surface, the first support surface, the second support surface, and the third support surface all can provide good planar support for the flexible display, so that use security of the flexible display and user experience can be effectively ensured.

During specific disposition, the flexible display may be fastened on the third support surface, to implement fastening between the flexible display and the third support surface. Alternatively, the flexible display may be lapped on the third support surface, that is, the flexible display and the third support surface may not in a fastening relationship.

In addition, the third support surface may be a flat surface, or may be a protruding arc-shaped surface, or a surface that is partially a flat surface and partially a curved surface.

For example, a side that is of the third support surface and that is adjacent to the first support surface is a first curved surface, a side that is of the third support surface and that is adjacent to the second support surface is a second curved surface, and a flat surface is disposed between the first curved surface and the second curved surface.

In an example, the first rotating member and the first connecting rod in the first foldable assembly may be both located on a side that is of the first body and that is opposite to the first support surface, to avoid a case in which a support effect of the first support surface on the flexible display is affected as the first rotating member and the first connecting rod protrude from the first support surface.

Correspondingly, the second rotating member and the second connecting rod in the second foldable assembly may be both located on a side that is of the second body and that is opposite to the second support surface, to avoid a case in which a support effect of the second support surface on the flexible display is affected as the second rotating member and the second connecting rod protrude from the second support surface.

In an example, the second end of the first connecting rod has a first pin hole, the first end of the second rotating member has a second pin hole, and the first connecting rod is rotatably connected to the second rotating member via a pin shaft that penetrates the first pin hole and the second pin hole. The second end of the second connecting rod has a third pin hole, the first end of the first rotating member has a fourth pin hole, and the second connecting rod is rotatably connected to the first rotating member via a pin shaft that penetrates the third pin hole and the fourth pin hole.

In an example, when the hinge changes from an unfolded state to a folded state, the first foldable assembly and the second foldable assembly rotate toward each other, the first rotating member and the first body rotate synchronously, and the second rotating member and the second body rotate synchronously. The first rotating member drives the first connecting rod to move, the first connecting rod drives the second body to approach the main shaft, the second rotating member drives the second connecting rod to move, and the second connecting rod drives the first body to approach the main shaft. This can shorten a length of the hinge. After the hinge is used in a foldable electronic device like a mobile phone, when the foldable electronic device is folded, an action force of stretching or compressing the flexible display can be avoided. Therefore, use security and reliability of the flexible display can be ensured.

In addition, when the hinge changes from the folded state to the unfolded state, the first foldable assembly and the second foldable assembly rotate away from each other, the first rotating member and the first body rotate synchronously, and the second rotating member and the second body rotate synchronously. The first rotating member drives the first connecting rod to move, the first connecting rod drives the second body to be away from the main shaft, the second rotating member drives the second connecting rod to move, and the second connecting rod drives the first body to be away from the main shaft. This can increase a length of the hinge.

In the hinge provided in this application, a folding function of the hinge may be implemented via the main shaft, the first rotating member, the first body, the first connecting rod, the second rotating member, the second body, and the second connecting rod. In addition, in the processes of folding and unfolding the hinge, the length of the hinge may further change, to avoid an action force of stretching or compressing the flexible display. In addition, the hinge uses a small quantity of parts, and has a simple structure, so that manufacturing costs and assembling costs of the hinge can be effectively reduced.

In an example, the main shaft may include a first shaft body and a second shaft body. The first shaft body has a convex first cylindrical surface, and the second shaft body has a concave second cylindrical surface. The first cylindrical surface and the second cylindrical surface are disposed opposite to each other, so that the first shaft body and the second shaft body enclose first arc-shaped space. The first end of the first rotating member has a first arc-shaped arm, and the first arc-shaped arm is located in the first arc-shaped space between the first cylindrical surface and the second cylindrical surface. That is, the first end of the first rotating member is rotatably connected to the main shaft through the first arc-shaped arm and the first arc-shaped space.

In addition, during specific disposition, the first shaft body may further have a convex third cylindrical surface, and the second shaft body has a concave fourth cylindrical surface. The third cylindrical surface and the fourth cylindrical surface are disposed opposite to each other, so that the first shaft body and the second shaft body enclose second arc-shaped space. The first end of the second rotating member has a second arc-shaped arm, and the second arc-shaped arm is located in the second arc-shaped space between the third cylindrical surface and the fourth cylindrical surface. That is, the first end of the second rotating member is rotatably connected to the main shaft through the second arc-shaped arm and the second arc-shaped space.

In the processes of folding and unfolding the foldable electronic device, the first arc-shaped arm rotates along the first arc-shaped space, and the second arc-shaped arm rotates along the second arc-shaped space.

In addition, in the process of folding the foldable electronic device, the first arc-shaped arm rotates out of the first arc-shaped space, and the second arc-shaped arm rotates out of the second arc-shaped space. In the process of unfolding the foldable electronic device, the first arc-shaped arm rotates into the first arc-shaped space, and the second arc-shaped arm rotates into the second arc-shaped space.

The main shaft may include a first shaft body and a second shaft body. During manufacturing, the first shaft body and the second shaft body can be separately manufactured, so that manufacturing time can be shortened. During assembling, the first arc-shaped arm of the first rotating member may be disposed between the first cylindrical surface and the second cylindrical surface, and then the first shaft body and the second shaft body are fastened via a fastener like a screw, to implement assembling among the first rotating member, the second rotating member, the first shaft body, and the second shaft body.

During specific disposition, a surface that is of the first shaft body and that is away from the first cylindrical surface may be a flat surface. This helps implement flat disposition of the hinge.

In addition, a surface that is of the first shaft body and that is away from the third cylindrical surface may be a flat surface. This helps implement flat disposition of the hinge.

After the hinge is used in the foldable electronic device, a back side of the flexible display in the foldable electronic device may be attached to the foregoing two surfaces. That is, the two surfaces can provide a good bearing effect for the flexible display. In addition, because the two surfaces are flat surfaces, flatness of flexible display can be ensured.

In an example, the first body may have a first sliding groove, the first rotating member may have a first sliding end, and the first sliding end may be slidably disposed in the first sliding groove, to implement a slidable connection between the first body and the first rotating member.

In addition, the second body may have a second sliding groove, the second rotating member may have a second sliding end, and the second sliding end may be slidably disposed in the second sliding groove, to implement a slidable connection between the second body and the second rotating member.

In the process of folding the foldable electronic device, the first sliding end slides into the first sliding groove, and the second sliding end slides into the second sliding groove. In the process of unfolding the foldable electronic device, the first sliding end slides out of the first sliding groove, and the second sliding end slides out of the second sliding groove.

In an example, the first foldable assembly may further include a first suspension assembly. The first rotating member may have a first mounting groove, and the first suspension assembly is disposed in the first mounting groove; and the first suspension assembly is in sliding contact with the first body, and is configured to provide a damping force when the first rotating member slides relative to the first body.

The first mounting groove configured to accommodate the first suspension assembly is provided in the first rotating member, so that compactness of the first foldable assembly can be improved, and a miniaturization design of the hinge can be implemented.

In addition, the second foldable assembly may further include a second suspension assembly. The second rotating member may have a second mounting groove, and the second suspension assembly is disposed in the second mounting groove; and the second suspension assembly is in sliding contact with the second body, and is configured to provide a damping force when the second rotating member slides relative to the second body.

The second mounting groove configured to accommodate the second suspension assembly is provided in the second rotating member, so that compactness of the second foldable assembly can be improved, and a miniaturization design of the hinge can be implemented.

It may be understood that, when the hinge is specifically disposed, the first suspension assembly or the second suspension assembly may be omitted, so that a quantity of used parts of the hinge can be reduced, and a suspension function can be implemented via the first suspension assembly or the second suspension assembly.

In an example, the hinge may further include a cover assembly, and the cover assembly includes a first plate body, a second plate body, and a third plate body. The first plate body is fastened to the first body, the second plate body is fastened to the second body, and the third plate body is fastened to the main shaft. The cover assembly can be disposed to effectively shield and protect a part like the first rotating member, the second rotating member, the first suspension assembly, or the second suspension assembly in the hinge for effectively shielding an external foreign matter. This can improve use safety of the hinge.

In an example, the hinge may further include a synchronization assembly, where the synchronization assembly is in transmission connection to the first body, the main shaft, and the second body for the first foldable assembly and the second foldable assembly to synchronously and reversely rotate.

During specific disposition, the synchronization assembly may include a first synchronization member and a second synchronization member. The first synchronization member is rotatably connected to the main shaft, and a rotation axis center of the first synchronization member coincides with a rotation axis center of the first rotating member; and the second synchronization member is rotatably connected to the main shaft, and a rotation axis center of the second synchronization member coincides with a rotation axis center of the second rotating member. The first synchronization member has a first tooth-shaped part and a first sliding part, and the second synchronization member has a second tooth-shaped part and a second sliding part. The first tooth-shaped part is engaged with the second tooth-shaped part, the first sliding part is slidably connected to the first body, and the second sliding part is slidably connected to the second body.

The synchronization assembly can be disposed to ensure smoothness of the first foldable assembly and the second foldable assembly during relative movement, so that use experience and reliability of the hinge can be improved.

During specific disposition, the hinge may include a first foldable assembly and a second foldable assembly that are correspondingly disposed. Alternatively, a plurality of first foldable assemblies and a plurality of second foldable assemblies that are disposed in a one-to-one correspondence may be included, to improve force-bearing performance of the hinge.

When the hinge includes a plurality of first foldable assemblies and a plurality of second foldable assemblies, the plurality of first foldable assemblies and the plurality of second foldable assemblies are disposed in a direction parallel to a length direction (an axial direction) of the main shaft. During specific setting, quantities of first foldable assemblies and second foldable assemblies may be properly set based on an actual requirement. This is not limited in this application.

### BRIEF DESCRIPTION OF DRAWINGS

FIG. 1 is a diagram of a structure of a foldable electronic device in an unfolded state according to an embodiment of this application;
FIG. 2 is a diagram of a foldable electronic device that is being fully folded according to an embodiment of this application;
FIG. 3 is a diagram of a structure of a hinge in an unfolded state according to an embodiment of this application;
FIG. 4 is a diagram of a structure of a hinge that is being fully folded according to an embodiment of this application;
FIG. 5 is a diagram of a partial structure of a part A in FIG. 3;
FIG. 6 is a diagram of a structure of a hinge in an unfolded state according to an embodiment of this application from another perspective;
FIG. 7 is a diagram of a partial structure of a part B in FIG. 6;
FIG. 8 is a diagram of an exploded structure of a partial structure of a hinge according to an embodiment of this application;
FIG. 9 is a diagram of an exploded structure of a partial structure of a hinge according to an embodiment of this application;
FIG. 10 is a diagram of a partial cross-sectional structure of a hinge according to an embodiment of this application;
FIG. 11 is a diagram of an exploded structure of a first suspension assembly according to an embodiment of this application;
FIG. 12 is a diagram of an exploded structure of a partial structure of a hinge according to an embodiment of this application;
FIG. 13 is a diagram of a structure of another hinge in an unfolded state according to an embodiment of this application;
FIG. 14 is a diagram of a structure of a foldable electronic device in an unfolded state according to an embodiment of this application;
FIG. 15 is a diagram of a partial structure of a part C in FIG. 14;
FIG. 16 is a diagram of a structure of a foldable electronic device in an unfolded state according to an embodiment of this application;
FIG. 17 is a diagram of a partial cross-sectional structure of a foldable electronic device in an unfolded state according to an embodiment of this application; and
FIG. 18 is a diagram of a partial cross-sectional structure of a foldable electronic device that is being fully folded according to an embodiment of this application.

### DESCRIPTION OF EMBODIMENTS

To make the objectives, technical solutions, and advantages of this application clearer, the following further describes this application in detail with reference to the accompanying drawings. To facilitate understanding of a hinge provided in embodiments of this application, the following first describes application scenarios of the hinge.

The hinge provided in embodiments of this application can be used in a foldable electronic device. The foldable electronic device is specifically an electronic device that can change its form through folding, rotation, or the like. Under different use requirement conditions, a user may fold or unfold the foldable electronic device to meet different requirements of the user.

When the user needs to carry on the foldable electronic device, the user may fold the foldable electronic device, to reduce a size of the foldable electronic device, so that portability is improved. When the user uses the foldable electronic device, the user may unfold the foldable electronic device, to provide a large display size and a large operation area, so that use convenience is improved. In actual application, there may be a plurality of types of foldable electronic devices. For example, the foldable electronic device may be specifically a mobile phone, a tablet computer, a notebook computer, an e-book, or the like.

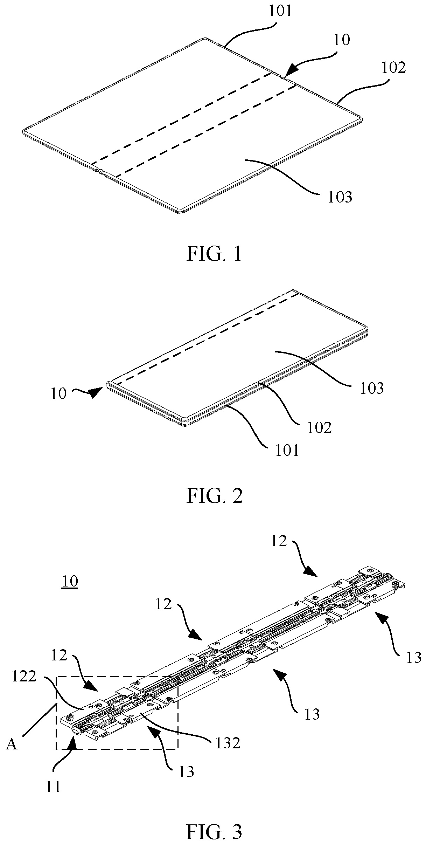

As shown in FIG. 1, a mobile phone is used as an example. The mobile phone may include a first housing 101 and a second housing 102 that are connected via a hinge 10. Under an action of the hinge 10, actions such as relative rotation and movement can be generated between the first housing 101 and the second housing 102. A flexible display 103 (for example, an OLED screen) may be disposed on a surface of the first housing 101 and a surface of the second housing 102. As shown in FIG. 1, when the mobile phone is unfolded, the flexible display 103 may provide a large display area and a large operation area, to improve use performance. As shown in FIG. 2, after the mobile phone is folded, the flexible display 103 may be located on an outer surface of the mobile phone, so that a size of the mobile phone can be reduced for improving portable performance of the mobile phone.

When the mobile phone is in an unfolded state, the flexible display 103 is unfolded accordingly, to provide a large display size and a large touch size. In an actual use process, the flexible display 103 is touched or pressed by a human hand. Therefore, a corresponding component needs to provide effective planar support for the flexible display 103, to prevent the flexible display 103 from being pressed and causing deformation, crack, or the like. In a current mobile phone, some hinges 10 cannot effectively support the flexible display 103, and therefore, reliability of using the flexible display 103 is reduced. Alternatively, in some current hinges 10, to provide good support for the flexible display 103, an additional component like a support needs to be used, and consequently complex structures, a large quantity of parts, and other problems occur.

In view of this, this application provides a hinge 10 that has a simple structure and can effectively support a flexible display.

To make the objectives, technical solutions, and advantages of this application clearer, the following further describes this application in detail with reference to accompanying drawings and specific embodiments.

Terms used in the following embodiments are merely intended to describe specific embodiments, but are not intended to limit this application. Terms "one", "a", and "this" of singular forms used in this specification and the appended claims of this application are also intended to include a form like "one or more", unless otherwise specified in the context clearly. It may be further understood that, in the following embodiments of this application, "at least one" means one, two, or more. Reference to "an embodiment" or the like described in this specification means that one or more embodiments of this application include a particular feature, structure, or characteristic described in combination with the embodiment. Therefore, in this specification, statements, such as "in an embodiment", "in some implementations", and "in other implementations", that appear at different places do not necessarily mean referring to a same embodiment, instead, the statements mean referring to "one or more but not all of embodiments", unless otherwise specifically emphasized in other ways. Terms "include", "have", and variants of the terms all mean "include but are not limited to", unless otherwise specifically emphasized in other ways.

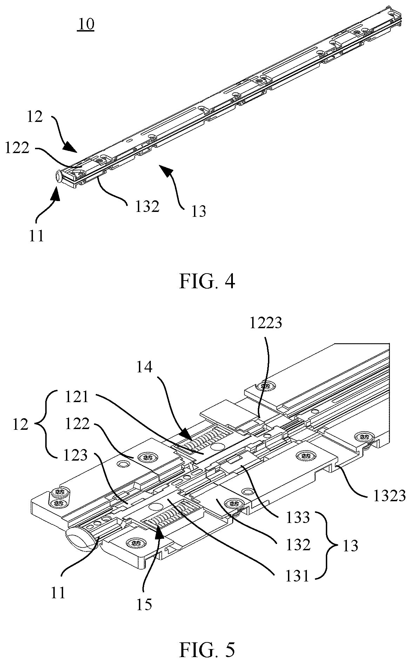

As shown in FIG. 3 and FIG. 4, in an example provided in this application, the hinge 10 may include a main shaft 11, and a first foldable assembly 12 and a second foldable assembly 13 that are symmetrically disposed with respect to the main shaft 11. The first foldable assembly 12 and the second foldable assembly 13 may rotate toward or away from each other, to implement a folding function of the hinge 10.

Refer to FIG. 3 and FIG. 5 together. Specifically, the first foldable assembly 12 includes a first rotating member 121, a first body 122, and a first connecting rod 123. The first rotating member 121 is rotatably connected to the main shaft 11, and is slidably connected to the first body 122. The second foldable assembly 13 includes a second rotating member 131, a second body 132, and a second connecting rod 133. The second rotating member 131 is rotatably connected to the main shaft 11, and is slidably connected to the second body 132. In addition, one end of the first connecting rod 123 is rotatably connected to the first body 122, and the other end of the first connecting rod 123 is rotatably connected to the second rotating member 131. One end of the second connecting rod 133 is rotatably connected to the second body 132, and the other end of the second connecting rod 133 is rotatably connected to the first rotating member 121.

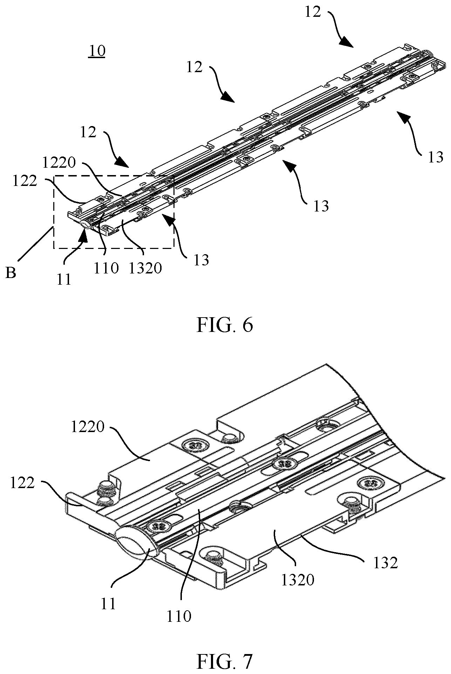

As shown in FIG. 6 and FIG. 7, the hinge 10 is in an unfolded state. The first body 122 has a first support surface 1220, and the second body 132 has a second support surface 1320. When the hinge 10 is in the unfolded state, the first support surface 1220 and the second support surface 1320 are located on a same plane. In an actual application, the first support surface 1220 and the second support surface 1320 can provide good planar support. When the flexible display is touched or pressed, the first support surface 1220 and the second support surface 1320 can effectively support the flexible display, so as to effectively prevent deformation of the flexible display, and effectively ensure use security of the flexible display and user experience. It may be understood that, in consideration of a size precision error or another factor, that the first support surface 1220 and the second support surface 1320 are located on a same plane means that the first support surface 1220 and the second support surface 1320 are approximately but not absolutely located on a same plane. In addition, as the main shaft 11 is located between the first body 122 and the second body 132, in an example provided in this application, the main shaft 11 may have a third support surface 110 for the hinge 10 to provide a good support effect for the flexible display. When the hinge 10 is in the unfolded state, the first support surface 1220, the second support surface 1320, and the third support surface 110 are located on a same plane. That is, the first support surface 1220, the second support surface 1320, and the third support surface 110 all can provide good planar support for the flexible display, so that use security of the flexible display and user experience can be effectively ensured. Alternatively, it may be understood that, to a specific extent, the third support surface 110 can connect the first support surface 1220 and the second support surface 1320, so that a coherent support plane can be formed.

During specific disposition, the third support surface 110 may be a flat surface, or may be a curved surface with a small curvature. Alternatively, the third support surface 110 may be a surface that is partially a flat surface and partially a curved surface. In an actual application, a shape of the third support surface 110 may be adaptively adjusted based on an actual requirement. Details are not described herein.

In addition, as shown in FIG. 1 and FIG. 2, in an outward-foldable mobile phone, the hinge 10 is located inside the flexible display 103. In processes of folding and unfolding the mobile phone, a rotation radius of the hinge 10 is less than a rotation radius of the flexible display 103. In the hinge 10 provided in this embodiment of this application, a length of the hinge 10 can change in the process of folding or unfolding the mobile phone, to prevent the hinge 10 from stretching or compressing the flexible display 103. Specifically, in the process of folding the mobile phone, the length of the hinge 10 can be shortened, so that an action force of stretching the flexible display 103 can be avoided. In the process of unfolding the mobile phone, the length of the hinge 10 can be increased, so that an action force of compressing the flexible display 103 can be avoided.

As shown in FIG. 3 and FIG. 5, in the hinge 10 provided in this application, the first rotating member 121 and the second rotating member 131 can generate a rotation motion relative to the main shaft 11. In addition, the first body 122 is slidably connected to the first rotating member 121, and the second body 132 is slidably connected to the second rotating member 131. Therefore, when the first rotating member 121 and the second rotating member 131 rotate relative to each other, the first body 122 and the second body 132 can generate a sliding action; and when the first body 122 and the second body 132 generate the sliding action, a connection length among the first body 122, the main shaft 11, and the second body 132 can be increased or shortened. Specifically, as shown in FIG. 3 to FIG. 5, when the hinge 10 changes from an unfolded state to a folded state, the first foldable assembly 12 and the second foldable assembly 13 rotate toward each other, the first rotating member 121 and the first body 122 rotate synchronously, and the second rotating member 131 and the second body 132 rotate synchronously. The first rotating member 121 is configured to enable the second body 132 to approach the main shaft 11 via the first connecting rod 123, and the second rotating member 131 is configured to enable the first body 122 to approach the main shaft 11 via the second connecting rod 133. In this case, the length of the hinge 10 can be shortened. It should be noted that rotation toward each other means that two parts rotate and move in directions of each other. For example, that the first foldable assembly 12 and the second foldable assembly 13 rotate toward each other means that the first foldable assembly 12 rotates and moves in a direction of the second foldable assembly 13, and the second foldable assembly 13 rotates and moves in a direction of the first foldable assembly 12.

When the hinge 10 changes from the folded state to the unfolded state, the first foldable assembly 12 and the second foldable assembly 13 rotate away from each other, the first rotating member 121 and the first body 122 rotate synchronously, and the second rotating member 131 and the second body 132 rotate synchronously. The first rotating member 121 is configured to enable the second body 132 to be away from the main shaft 11 via the first connecting rod 123, and the second rotating member 131 is configured to enable the first body 122 to be away from the main shaft 11 via the second connecting rod 133. In this case, the length of the hinge 10 can be increased. It should be noted that rotation away from each other means that two parts rotate and move in directions away from each other. For example, that the first foldable assembly 12 and the second foldable assembly 13 rotate away from each other means that the first foldable assembly 12 rotates and moves in a direction away from the second foldable assembly 13, and the second foldable assembly 13 rotates and moves in a direction away from the first foldable assembly 12.

In the hinge 10 provided in this application, a folding function of the hinge 10 may be implemented via the main shaft 11, the first rotating member 121, the first body 122, the first connecting rod 123, the second rotating member 131, the second body 132, and the second connecting rod 133. In addition, in the processes of folding and unfolding the hinge 10, the length of the hinge 10 may further change, to avoid an action force of stretching or compressing the flexible display. In addition, the hinge 10 uses a small quantity of parts, and has a simple structure, so that manufacturing costs and assembling costs of the hinge 10 can be effectively reduced. Alternatively, it may be understood that in some current hinges 10, in folding and unfolding processes, structures such as a plurality of central shafts and rotating members that cooperate with the plurality of central shafts needs to be used, to implement a function of changing a length. A large quantity of used parts and a complex assembly process lead to disadvantages such as high manufacturing costs and a complex assembly technique.

The following specifically describes a specific structure of the hinge 10 provided in embodiments of this application.

As shown in FIG. 3, FIG. 4, and FIG. 6, in an example provided in this application, three first foldable assemblies 12 and three second foldable assemblies 13 are disposed in a length direction of the main shaft 11. A structure of each first foldable assembly 12 is basically the same. Correspondingly, a structure of each second foldable assembly 13 is also basically the same. The first foldable assembly 12 and the second foldable assembly 13 are disposed in a one-to-one correspondence. In an example provided in this application, a plurality of first foldable assemblies 12 and a plurality of second foldable assemblies 13 are used to effectively improve structural strength and stability of the hinge 10 during use.

In addition, as shown in FIG. 6 and FIG. 7, each first foldable assembly 12 has a first support surface 1220, and first support surfaces 1220 of a plurality of first foldable assemblies 12 are located on a same plane. Correspondingly, each second foldable assembly 13 has a second support surface 1320, and second support surfaces 1320 of a plurality of second foldable assemblies 123 are located on a same plane. In addition, the plurality of first foldable assemblies 12 may be fastened via screws, through welding, or the like, and the plurality of second foldable assemblies 13 may also be fastened to each other via screws, through welding, or the like. This is not limited in this application.

Certainly, in another example, the hinge 10 may alternatively include one first foldable assembly 12 and one second foldable assembly 13. Alternatively, two or more first foldable assemblies 12 and two or more second foldable assemblies 13 may be included. A quantity of disposed first foldable assemblies 12 and a quantity of disposed second foldable assemblies 13 are not limited in this application.

For ease of understanding of the technical solutions in this application, the following uses an example in which the hinge 10 includes one first foldable assembly 12 and one second foldable assembly 13 for specific description.

In actual application, the main shaft 11 may have various structure types.

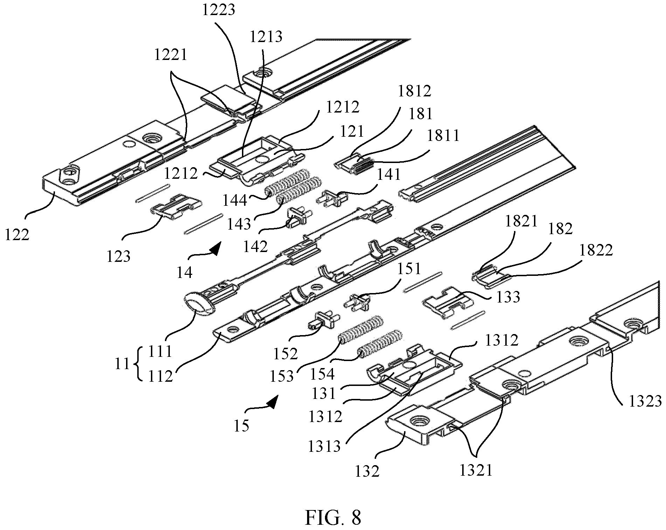

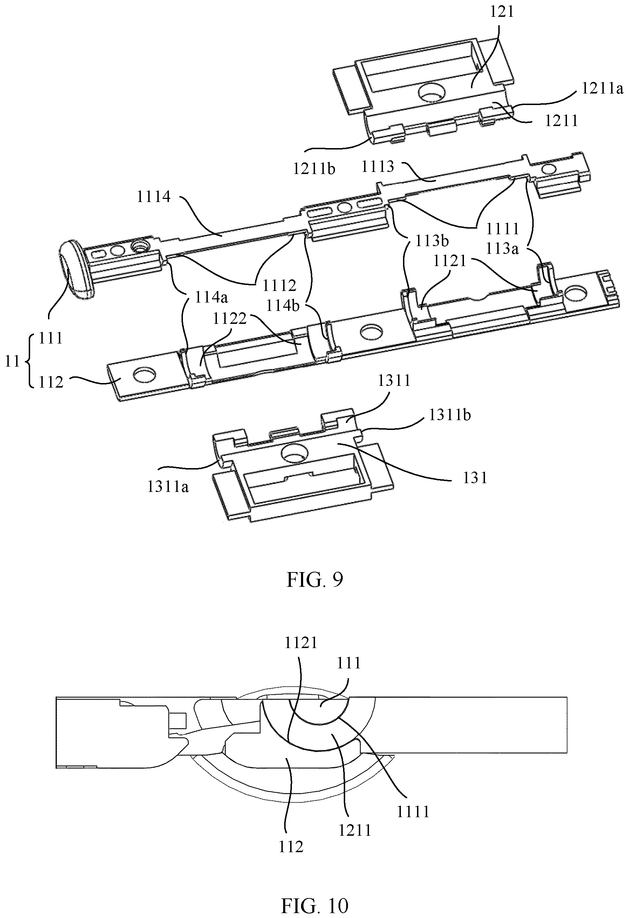

For example, as shown in FIG. 8 and FIG. 9, the main shaft 11 may include a first shaft body 111 and a second shaft body 112.

During specific disposition, the first rotating member 121 and the main shaft 11 may be rotatably connected via a cylindrical structure.

Specifically, the first shaft body 111 has a convex first cylindrical surface 1111, the second shaft body 112 has a concave second cylindrical surface 1121, and the first cylindrical surface 1111 and the second cylindrical surface 1121 are disposed opposite to each other.

As shown in FIG. 9 and FIG. 10, the first rotating member 121 has a first arc-shaped arm 1211, and the first arc-shaped arm 1211 is located in first arc-shaped space formed by the first cylindrical surface 1111 and the second cylindrical surface 1121. In addition, an inner concave surface (not shown in the figure) of the first arc-shaped arm 1211 is attached to the first cylindrical surface 1111, and an outer convex surface (not shown in the figure) of the first arc-shaped arm 1211 is attached to the second cylindrical surface 1121, to implement a rotatable connection between the first rotating member 121 and the main shaft 11. An axis center of the first arc-shaped arm 1211, an axis center of the first cylindrical surface 1111, and an axis center of the second cylindrical surface 1121 all coincide. It should be noted that an arc-shaped arm refers to a part that is of a circular ring and that is cut by a sector, and both an inner concave surface and an outer convex surface of the arc-shaped arm are cylindrical surfaces.

In actual use, the first arc-shaped arm 1211 of the first rotating member 121 is limited to the first arc-shaped space formed by the first cylindrical surface 1111 and the second cylindrical surface 1121 of the main shaft 11, so that the first arc-shaped arm 1211 of the first rotating member 121 can rotate and move only in the first arc-shaped space formed by the first cylindrical surface 1111 and the second cylindrical surface 1121.

In addition, as shown in FIG. 9, in an example provided in this application, the main shaft 11 further has a stop surface 113a and a stop surface 113b that are disposed opposite to each other, to prevent the first rotating member 121 from sliding in an axial direction of the main shaft 11. The stop surface 113a is configured to fit an end surface 1211a of the first arc-shaped arm, and the stop surface 113b is configured to fit an end surface 1211b of the first arc-shaped arm, so that the first rotating member 121 can be prevented from sliding in the axial direction of the main shaft 11.

In an example provided in this application, one part of the stop surface 113a is located in the first shaft body 111, and the other part of the stop surface 113a is located in the second shaft body 112. One part of the stop surface 113b is located in the first shaft body 111, and the other part of the stop surface 113b is located in the second shaft body 112. It may be understood that, in another example, the stop surface 113a may also be completely disposed in the first shaft body 111, or the stop surface 113a may also be completely disposed in the second shaft body 112. Correspondingly, the stop surface 113b may also be completely disposed in the first shaft body 111, or the stop surface 113b may also be completely disposed in the second shaft body 112. Alternatively, in another example, another structure may be disposed to prevent the first rotating member 121 from sliding in the axial direction. This is not specifically limited in this application.

In addition, as shown in FIG. 9, in the example provided in this application, structures of the first rotating member 121 and the second rotating member 131 are basically the same. A structure that is in the main shaft 11 and that is configured to connect to the first rotating member 121 is also basically the same as a structure that is in the main shaft 11 and that is configured to connect to the second rotating member 131.

In short, the second rotating member 131 has a second arc-shaped arm 1311, and the second arc-shaped arm 1311 is located in second arc-shaped space formed by a third cylindrical surface 1112 and a fourth cylindrical surface 1122. In addition, an inner concave surface (not shown in the figure) of the second arc-shaped arm 1311 is attached to the third cylindrical surface 1112, and an outer convex surface (not shown in the figure) of the second arc-shaped arm 1311 is attached to the fourth cylindrical surface 1122, to implement a rotatable connection between the second rotating member 131 and the main shaft 11. An axis center of the second arc-shaped arm 1311, an axis center of the third cylindrical surface 1112, and an axis center of the fourth cylindrical surface 1122 all coincide.

In addition, the main shaft 11 further has a stop surface 114a and a stop surface 114b that are disposed opposite to each other. The stop surface 114a is configured to fit an end surface 1311a of the second arc-shaped arm, and the stop surface 114b is configured to fit an end surface 1311b of the second arc-shaped arm, so that the first rotating member 121 can be prevented from sliding in the axial direction of the main shaft 11.

Refer to FIG. 10. In this case, the hinge 10 is in an unfolded state. In a process of folding the hinge 10, the first arc-shaped arm 1211 rotates out of the first arc-shaped space, and the second arc-shaped arm 1311 rotates out of the second arc-shaped space. That the first arc-shaped arm 1211 rotates out of the first arc-shaped space may be understood as that a part of the first arc-shaped arm 1211 in the second arc-shaped space decreases. That the second arc-shaped arm 1311 rotates out of the second arc-shaped space may be understood as that a part of the second arc-shaped arm 1311 in the second arc-shaped space decreases. It can be seen from FIG. 10 that the first arc-shaped arm 1211 rotates anticlockwise.

In a process of unfolding the hinge 10, the first arc-shaped arm 1211 rotates into the first arc-shaped space, and the second arc-shaped arm 1311 rotates into the second arc-shaped space. The rotation-into means that the first arc-shaped arm 1211 is gradually rotated into the second arc-shaped space, and the part of the first arc-shaped arm 1211 in the second arc-shaped space increases. In an example provided in this application, one part of the stop surface 114a is located in the first shaft body 111, and the other part of the stop surface 114a is located in the second shaft body 112. One part of the stop surface 114b is located in the first shaft body 111, and the other part of the stop surface 114b is located in the second shaft body 112. It may be understood that, in another example, the stop surface 114a may also be completely disposed in the first shaft body 111, or the stop surface 114a may also be completely disposed in the second shaft body 112. Correspondingly, the stop surface 114b may also be completely disposed in the first shaft body 111, or the stop surface 114b may also be completely disposed in the second shaft body 112. Alternatively, in another example, another structure may be disposed to prevent the first rotating member 121 from sliding in the axial direction. This is not specifically limited in this application.

In the example provided in this application, structures of the first rotating member 121 and the second rotating member 131 are the same. Therefore, the first rotating member 121 and the second rotating member 131 may be replaced with each other, so that assembly difficulty can be reduced, and a manufacturing process can also be simplified.

In addition, in the example provided in this application, the main shaft 11 includes the first shaft body 111 and the second shaft body 112. During manufacturing, the first shaft body 111 and the second shaft body 112 can be separately manufactured, so that manufacturing time can be shortened. During assembling, the first arc-shaped arm 1211 of the first rotating member 121 may be disposed between the first cylindrical surface 1111 and the second cylindrical surface 1121, and the second arc-shaped arm 1311 of the second rotating member 131 may be disposed between the third cylindrical surface 1112 and the fourth cylindrical surface 1122. Then, the first shaft body 111 and the second shaft body 112 are fastened via a fastener like a screw, to implement assembling among the first rotating member 121, the second rotating member 131, the first shaft body 111, and the second shaft body 112.

In addition, in the example provided in this application, the first cylindrical surface 1111 is specifically a semi-cylindrical surface. That is, a surface 1113 that is of the first shaft body 111 and that is away from the first cylindrical surface 1111 is a flat surface. The third cylindrical surface 1112 is also a semi-cylindrical surface, that is, a surface 1114 that is of the first shaft body 111 and that is away from the third cylindrical surface 1112 is a flat surface. In the example provided in this application, after the surface 1113 and the surface 1114 are set as flat surfaces, flatness of the hinge 10 is improved. When the hinge 10 is in the unfolded state, the hinge 10 may be a flat surface, which can improve flatness of the hinge 10.

After the hinge 10 is used in a foldable mobile phone, when the hinge 10 is in the unfolded state, the back of a flexible display may be attached to the surface 1113 and the surface 1114, so that the flexible display can be effectively supported, and flatness of the flexible display can be improved. In addition, as shown in FIG. 5 and FIG. 9, in an example provided in this application, the axis center of the first cylindrical surface 1111 does not overlap the axis center of the third cylindrical surface 1112. A central axis of the first cylindrical surface 1111 may be referred to as a first central axis, and a central axis of the third cylindrical surface 1112 may be referred to as a second central axis. The first central axis may be used as a rotation axis center of the first foldable assembly 12, so that the first rotating member 121 of the first foldable assembly 12 can rotate by using the first central axis as the rotation axis center. The second central axis may be used as a rotation axis center of the second foldable assembly 13, so that the second rotating member 131 of the second foldable assembly 13 can rotate by using the second central axis as the rotation axis center. In the example provided in this application, the first central axis and the second central axis are two central axes that are parallel to each other with a specific spacing. Therefore, in a process of folding or unfolding the hinge 10, the first foldable assembly 12 and the second foldable assembly 13 can have sufficient rotation space, to avoid interference between the first foldable assembly 12 and the second foldable assembly 13. In addition, in the example provided in this application, two central axes may be provided by a single main shaft 11. Therefore, a quantity of used parts can be reduced. It may be understood that, in another example, the main shaft 11 and the first rotating member 121 may alternatively be rotatably connected via another structure. Correspondingly, the main shaft 11 and the second rotating member 131 may also be rotatably connected via another structure. Details are not described herein.

In addition, as shown in FIG. 8, in the example provided in this application, the first body 122 and the first rotating member 121 are slidably connected via structures of a sliding groove and a sliding end.

Specifically, the first body 122 has a first sliding groove 1221, the first rotating member 121 has a first sliding end 1212, and the first sliding end 1212 is slidably disposed in the first sliding groove 1221.

It may be understood that, in another example, disposing positions of the first sliding groove 1221 and the first sliding end 1212 may be interchanged. For example, the first sliding end 1212 may be disposed in the first body 122, and the first sliding groove 1221 may be provided in the first rotating member 121. Details are not described herein.

In addition, as shown in FIG. 8, the second body 132 and the second rotating member 131 are also slidably connected via structures of a sliding groove and a sliding end.

Specifically, the second body 132 has a second sliding groove 1321, the second rotating member 131 has a second sliding end 1312, and the second sliding end 1312 is slidably disposed in the second sliding groove 1321.

In the folding process, the first sliding end 1212 slides into the first sliding groove 1221, and the second sliding end 1312 slides into the second sliding groove 1321. That the first sliding end 1212 slides into the first sliding groove 1221 may be understood as that a part of the first sliding end 1212 in the first sliding groove 1221 increases; and that the second sliding end 1312 slides into the second sliding groove 1321 may be understood as that a part of the second sliding end 1312 in the second sliding groove 1321 increases.

In the unfolding process, the first sliding end 1212 slides out of the first sliding groove 1221, and the second sliding end 1312 slides out of the second sliding groove 1321. That the first sliding end 1212 slides out of the first sliding groove 1221 may be understood as that a part of the first sliding end 1212 in the first sliding groove 1221 decreases; and that the second sliding end 1312 slides out of the second sliding groove 1321 may be understood as that a part of the second sliding end 1312 in the second sliding groove 1321 decreases.

It may be understood that, in another example, disposing positions of the second sliding groove 1321 and the second sliding end 1312 may be interchanged. For example, the second sliding end 1312 may be disposed in the second body 132, and the second sliding groove 1321 may be provided in the second rotating member 131. Details are not described herein.

Alternatively, in another example, the first body 122 and the first rotating member 121 may alternatively be slidably connected via another structure form. Correspondingly, the second body 132 and the second rotating member 131 may alternatively be slidably connected via another structure form. This is not limited in this application.

In addition, as shown in FIG. 8, in the example provided in this application, the first foldable assembly 12 further includes a first suspension assembly 14, so that a suspension function at a folding angle can be implemented. The first rotating member 121 has a first mounting groove 1213, and the first suspension assembly 14 is disposed in the first mounting groove 1213. The first suspension assembly 14 is in sliding contact with the first body 122, and is configured to provide a damping force when the first rotating member 121 and the first body 122 slide relative to each other.

In the example provided in this application, the first mounting groove 1213 configured to accommodate the first suspension assembly 14 is provided in the first rotating member 121, so that compactness of the first foldable assembly 12 can be improved, and a miniaturization design of the hinge 10 can be implemented.

When the first suspension assembly 14 is set, the first suspension assembly 14 may have various structure types.

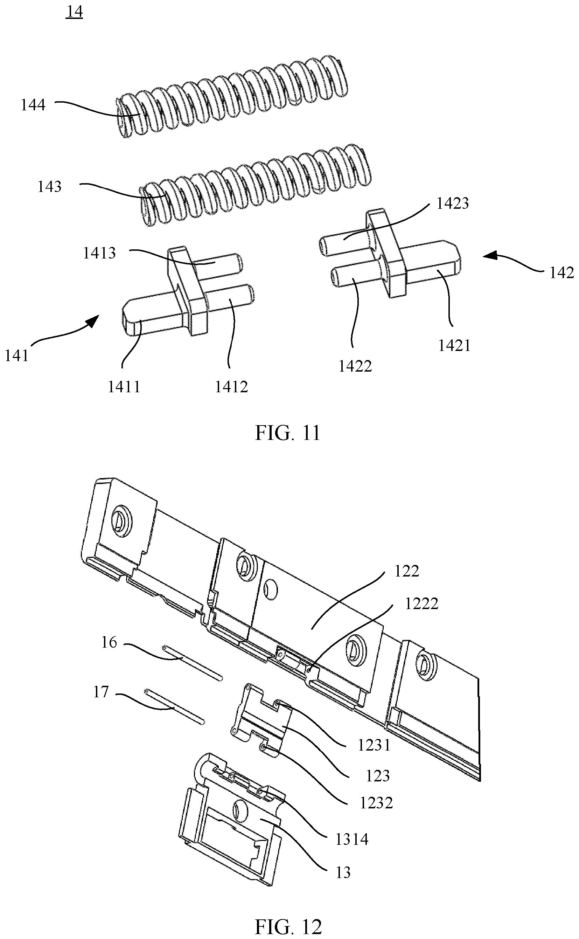

For example, as shown in FIG. 11, in an example provided in this application, the first suspension assembly 14 includes a suspension member 141, a suspension member 142, a first spring 143, and a second spring 144.

As shown in FIG. 11, the suspension member 141 has a protrusion 1411, a positioning post 1412, and a positioning post 1413. The suspension member 142 has a protrusion 1421, a positioning post 1422, and a positioning post 1423. One end of the first spring 143 is sleeved on a periphery of the positioning post 1412, and the other end of the first spring 143 is sleeved on a periphery of the positioning post 1422. One end of the second spring 144 is sleeved on a periphery of the positioning post 1413, and the other end of the second spring 144 is sleeved on a periphery of the positioning post 1423.

As shown in FIG. 8 and FIG. 11, under action of an elastic force of the first spring 143 and an elastic force of the second spring 144, the protrusion 1411 of the suspension member 141 and the protrusion 1421 of the suspension member 142 can elastically abut against an inner wall of the first sliding groove 1221.

When the first body 122 and the first rotating member 121 slide relative to each other, the first rotating member 121 can drive the first suspension assembly 14 to move synchronously, so that the protrusion 1411, the protrusion 1421, and the inner wall of the first sliding groove 1221 have relative friction; and under an effect of a friction force, a damping force for the hinge 10 during folding or unfolding can be provided.

In addition, the inner wall of the first sliding groove 1221 further has a recessed part (not marked in the figure). After the protrusion 1411 and the protrusion 1421 slide into the recessed part, a sliding position between the first rotating member 121 and the first body 122 may be maintained, to implement a suspension function of the hinge 10.

For example, after the protrusion 1411 and the protrusion 1421 slide into the recessed part, the hinge 10 is in an unfolded state, so that a mobile phone can be prevented from being folded randomly, and user experience can be improved. Alternatively, after the protrusion 1411 and the protrusion 1421 slide into the recessed part, the hinge 10 is in a fully-folded state, so that the mobile phone can be prevented from being unfolded randomly, and security of the mobile phone is ensured.

In an actual application, in a length direction of the first sliding groove 1221, a plurality of recessed parts may be disposed, to implement a suspension function of the hinge 10 at a plurality of different angles.

Certainly, in another example, the first suspension assembly 14 may alternatively use a current commonly-used type. Details are not described herein.

In addition, as shown in FIG. 8, in the example provided in this application, the hinge 10 may further include a second suspension assembly 15. A structure of the second suspension assembly 15 is basically the same as that of the first suspension assembly 14.

In short, the second rotating member 131 has a second mounting groove 1313, and the second suspension assembly 15 is disposed in the second mounting groove 1313. The second suspension assembly 15 is in sliding contact with the second body 132, and is configured to provide a damping force when the second rotating member 131 and the second body 132 slide relative to each other. In the example provided in this application, the second suspension assembly 15 includes a suspension member 151, a suspension member 152, a first spring 153, and a second spring 154. A structure of the second suspension assembly 15 is basically the same as that of the first suspension assembly 14. A specific structure of the second suspension assembly 15 is described herein in detail.

In addition, in a specific application, the first connecting rod 123 is rotatably connected to the first body 122 and the second rotating member 131 in a plurality of manners.

For example, as shown in FIG. 8 and FIG. 12, in an example provided in this application, one end of the first connecting rod 123 has a pin hole 1231, the first body 122 has a pin hole 1222, and a pin shaft 16 is fastened in the pin hole 1231 and the pin hole 1222 through penetration, to implement a rotatable connection between the first connecting rod 123 and the first body 122.

In addition, the other end of the first connecting rod 123 has a pin hole 1232, the second rotating member 131 has a pin hole 1314, and the pin shaft 17 is fastened in the pin hole 1232 and the pin hole 1314 through penetration, to implement a rotatable connection between the first connecting rod 123 and the second rotating member 131.

It may be understood that, in another example, the first connecting rod 123, the first body 122, and the second rotating member 131 may also be rotatably connected via a current commonly-used structure. Details are not described herein.

In addition, in the example provided in this application, a structure of the first connecting rod 123 is basically the same as that of the second connecting rod 133. A connection structure among the second connecting rod 133, the second body 132, and the first rotating member 121 is basically the same as a connection structure among the first connecting rod 123, the first body 122, and the second rotating member 131. Details are not described herein.

In the example provided in this application, the first connecting rod 123 of the first foldable assembly 12 is rotatably connected to the second rotating member 131 of the second foldable assembly 13, and the second connecting rod 133 of the second foldable assembly 13 is rotatably connected to the first rotating member 121 of the first foldable assembly 12. Therefore, when the hinge 10 is folded or unfolded, the first foldable assembly 12 and the second foldable assembly 13 can move synchronously.

In addition, as shown in FIG. 8, in an example provided in this application, the hinge 10 further includes a synchronization assembly. When the hinge 10 is folded or unfolded, the synchronization assembly can enhance synchronization between the first foldable assembly 12 and the second foldable assembly 13, and can ensure smoothness of the hinge 10 during folding or unfolding. Specifically, the synchronization assembly may include a first synchronization member 181 and a second synchronization member 182. The first synchronization member 181 is rotatably connected to the main shaft 11, and a rotation axis center of the first synchronization member 181 coincides with a rotation axis center of the first rotating member 121. The second synchronization member 182 is rotatably connected to the main shaft 11, and a rotation axis center of the second synchronization member 182 coincides with a rotation axis center of the second rotating member 131. The first synchronization member 181 has a first tooth-shaped part 1811 and a first sliding end 1812, and the second synchronization member 182 has a second tooth-shaped part 1821 and a second sliding end 1822. The first tooth-shaped part 1811 is engaged with the second tooth-shaped part 1821, the first sliding end 1812 is slidably connected to the sliding groove 1223 in the first body 122, and the second sliding end 1822 is slidably connected to the sliding groove 1323 in the second body 132.

In a process of folding or unfolding the hinge 10, synchronous reverse rotation between the first synchronization member 181 and the second synchronization member 182 can be implemented through meshing between the first tooth-shaped part 1811 and the second tooth-shaped part 1821. In addition, because a gear structure has good dimension precision and force-bearing performance, smoothness of the hinge 10 during folding or unfolding can be improved. This helps improve user experience. The synchronous reverse rotation means that two parts have a same rotation speed and opposite rotation directions.

It may be understood that, in another example, a plurality of foregoing synchronization assemblies may be disposed in the hinge 10. A quantity of disposed synchronization assemblies is not limited in this application.

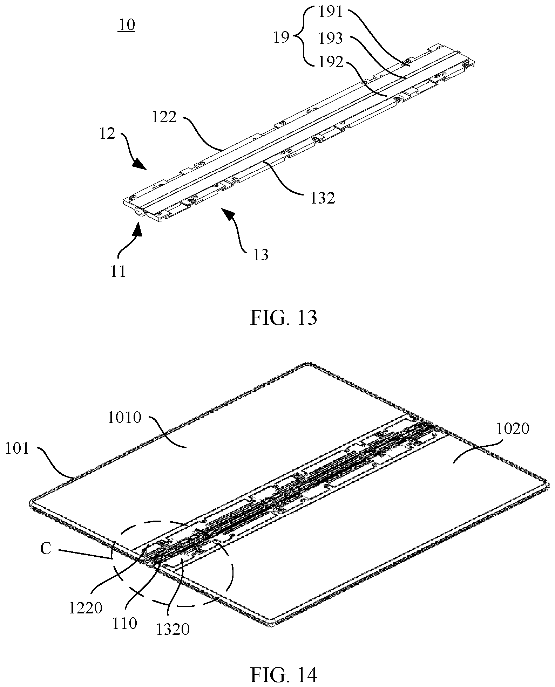

In addition, FIG. 13 is a diagram of a structure of a back side (for example, a side away from a flexible display) of the hinge 10. In an example provided in this application, the hinge 10 further includes a cover assembly 19. Specifically, the cover assembly 19 includes a first plate body 191, a second plate body 192, and a third plate body 193. The first plate body 191 is fastened to the first rotating member 121, the second plate body 192 is fastened to the second rotating member 131, and the third plate body 193 is fastened to the main shaft 11.

The cover assembly 19 can be disposed to effectively shield and protect some parts (such as the first rotating member, the second rotating member, the first suspension assembly, and the second suspension assembly) in the hinge 10 for effectively shielding an external foreign matter. This can improve use safety of the hinge 10.

In addition, after the hinge 10 is used in a foldable electronic device, the cover assembly 19 further helps improve integration of the foldable electronic device.

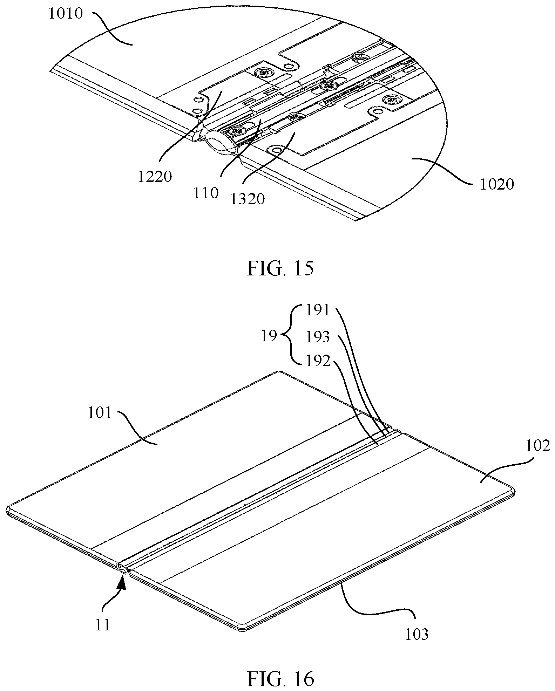

In addition, as shown in FIG. 14 to FIG. 18, an embodiment of this application further provides a foldable electronic device. FIG. 14 is a diagram of a structure of a front side of a foldable electronic device on which no flexible display is disposed. FIG. 16 is a diagram of a structure of a rear side of the foldable electronic device.

In an example provided in this application, the foldable electronic device includes a first housing 101 and a second housing 102, and a flexible display 103 (for example, an OLED screen) may be disposed on surfaces (for example, lower surfaces in FIG. 16) of the first housing 101 and the second housing 102.

In addition, as shown in FIG. 14 and FIG. 15, the first housing 101 has a first mounting surface 1010, the second housing 102 has a second mounting surface 1020, and a back side of a flexible display is attached to the first mounting surface 1010 and the second mounting surface 1020, to implement fastening among the flexible display, the first housing 101, and the second housing 102. When the hinge is in an unfolded state, the first mounting surface 1010, the second mounting surface 1020, the first support surface 1220, the second support surface 1320, and the third support surface 110 are located on a same plane. In addition, adjacent edges of the first mounting surface 1010 and the first support surface 1220 are spliced with each other, and adjacent edges of the second mounting surface 1020 and the second support surface 1320 are spliced with each other.

That is, the first mounting surface 1010, the second mounting surface 1020, the first support surface 1220, and the second support surface 1320 can all provide a good plane for the flexible display. When the flexible display is touched or pressed, the first mounting surface 1010, the second mounting surface 1020, the first support surface 1220, and the second support surface 1320 can all effectively support the flexible display, so as to effectively prevent deformation of the flexible display, and effectively ensure use security of the flexible display and user experience. In addition, after the adjacent edges of the first mounting surface 1010 and the first support surface 1220 are spliced with each other, a case in which a support effect for the flexible display is reduced as there is an obvious gap between the first mounting surface 1010 and the first support surface 1220 can be effectively avoided. Correspondingly, after the adjacent edges of the second mounting surface 1020 and the second support surface 1320 are spliced with each other, a case in which a support effect for the flexible display is reduced as there is an obvious gap between the second mounting surface 1020 and the second support surface 1320 can be effectively avoided.

During specific disposition, the flexible display 103 may be fastened on the third support surface 110 through bonding, or the like, to implement fastening between the flexible display 103 and the third support surface 110. Alternatively, the flexible display 103 may be lapped on the third support surface 110, that is, the flexible display 103 and the third support surface 110 are not in a fastening relationship, and the third support surface 110 may only support the flexible display 103.

In addition, in the example provided in this application, the first body 122 is fastened to the first housing 101. Therefore, in processes of folding and unfolding the hinge 10, relative positions between the first support surface 1220 and the first mounting surface 1020 do not change. Therefore, effective assembling can be maintained for providing a coherent support plane for the flexible display. Correspondingly, the second body 132 is fastened to the second housing 102. Therefore, in the processes of folding and unfolding the hinge 10, relative positions between the second support surface 1320 and the second mounting surface 1030 do not change. Therefore, effective assembling can be maintained for providing a coherent support plane for the flexible display.

In addition, as shown in FIG. 16, in the example provided in this application, a back side of the foldable electronic device can also be effectively assembled. Specifically, the first plate body 191 in the cover assembly 19 is effectively spliced with the first housing 101, and the second plate body 192 is effectively spliced with the second housing 102, thereby improving integration of the back side of the foldable electronic device, and preventing external impurities such as dust from entering the foldable electronic device.

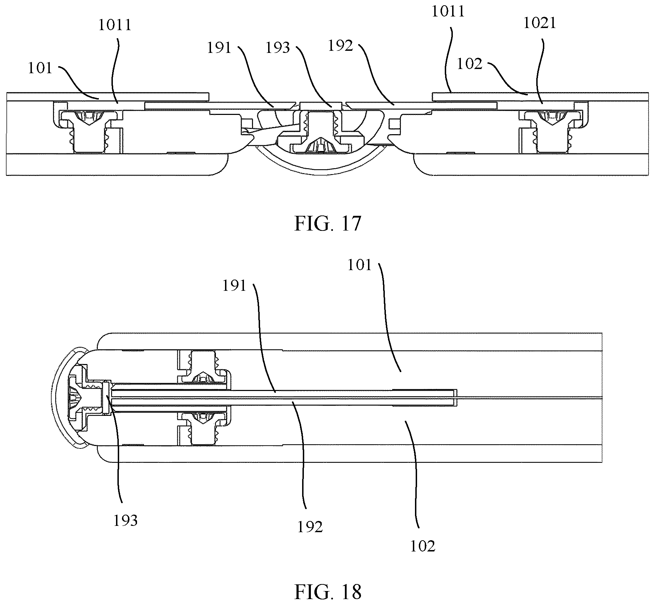

In addition, in the processes of folding and unfolding the foldable electronic device, an action such as slip may occur between the first plate body 191 and the first housing 101, and an action such as slip may occur between the second plate body 192 and the second housing 102. Therefore, as shown in FIG. 17, in the example provided in this application, the first housing 101 has space 1011 for the first plate body 191 to slide, and the second housing 102 has space 1021 for the second plate body 192 to slide.

As shown in FIG. 17, when the foldable electronic device is in an unfolded state, a part of the first plate body 191 is located in the space 1011, and a part of the second plate body 192 is located in the space 1021.

As shown in FIG. 18, when the foldable electronic device is in a fully-folded state, the first plate body 191 almost occupies the entire space 1011, and the second plate body 192 almost occupies the entire space 1021.

In summary, by disposing the space 1011 and the space 1021, not only continuity between the first plate body 191 and the first housing 101 and continuity between the second plate body 192 and the second housing 102 can be improved, but also sufficient movable space can be provided for the first plate body 191 and the second plate body 192. This can ensure integration and use reliability of the foldable electronic device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A foldable electronic device, comprising a first housing, a second housing, a flexible display, and a hinge, wherein
the hinge comprises a main shaft, a first foldable assembly, and a second foldable assembly, wherein the first foldable assembly and the second foldable assembly are disposed on two sides of the main shaft;
the first foldable assembly comprises a first rotating member, a first body, and a first connecting rod;
a first end of the first rotating member is rotatably connected to the main shaft, and a second end of the first rotating member is slidably connected to the first body;
the second foldable assembly comprises a second rotating member, a second body, and a second connecting rod;
a first end of the second rotating member is rotatably connected to the main shaft, and a second end of the second rotating member is slidably connected to the second body;
a first end of the first connecting rod is rotatably connected to the first body, and a second end of the first connecting rod is rotatably connected to the first end of the second rotating member;
a first end of the second connecting rod is rotatably connected to the second body, and a second end of the second connecting rod is rotatably connected to the first end of the first rotating member;
the first housing is fastened to the first body, and the second housing is fastened to the second body; and
a first part of the flexible display is fastened to the first housing, and a second part of the flexible display is fastened to the second housing, wherein
the first body has a first support surface for supporting the flexible display, the second body has a second support surface for supporting the flexible display, the first housing has a first mounting surface, the second housing has a second mounting surface, and a side that is of the flexible display and that is opposite to a display surface is fastened to the first mounting surface and the second mounting surface; and
when the hinge is in an unfolded state, the first mounting surface, the second mounting surface, the first support surface, and the second support surface are located on a same plane, adjacent edges of the first mounting surface and the first support surface are spliced with each other, and adjacent edges of the second mounting surface and the second support surface are spliced with each other.

2. The foldable electronic device according to claim 1, wherein the main shaft has a third support surface for supporting the flexible display, and when the hinge is in the unfolded state, the first mounting surface, the first support surface, the third support surface, the second support surface, and the second mounting surface are sequentially spliced to form a support surface for supporting the flexible display.

3. The foldable electronic device according to claim 2, wherein the flexible display is fastened on the third support surface, or the flexible display is lapped on the third support surface.

4. The foldable electronic device according to claim 2 or 3, wherein the third support surface is a flat surface or a curved surface.

5. The foldable electronic device according to claim 2 or 3, wherein a side that is of the third support surface and that is adjacent to the first support surface is a first curved surface, a side that is of the third support surface and that is adjacent to the second support surface is a second curved surface, and a flat surface is disposed between the first curved surface and the second curved surface.

6. The foldable electronic device according to any one of claims 1 to 5, wherein the first rotating member and the first connecting rod are both located on a side that is of the first body and that is opposite to the first support surface, and the second rotating member and the second connecting rod are both located on a side that is of the second body and that is opposite to the second support surface.

7. The foldable electronic device according to any one of claims 1 to 6, wherein the second end of the first connecting rod has a first pin hole, the first end of the second rotating member has a second pin hole, and the first connecting rod is rotatably connected to the second rotating member via a pin shaft that penetrates the first pin hole and the second pin hole; and
the second end of the second connecting rod has a third pin hole, the first end of the first rotating member has a fourth pin hole, and the second connecting rod is rotatably connected to the first rotating member via a pin shaft that penetrates the third pin hole and the fourth pin hole.

8. The foldable electronic device according to any one of claims 1 to 7, wherein when the first foldable assembly and the second foldable assembly rotate toward each other, the first mounting surface and the second mounting surface tend to be away from each other; and
the second body approaches the main shaft, and the first body approaches the main shaft.

9. The foldable electronic device according to any one of claims 1 to 8, wherein when the first foldable assembly and the second foldable assembly rotate away from each other,
the second body moves away from the main shaft, and the first body moves away from the main shaft.

10. The foldable electronic device according to any one of claims 1 to 9, wherein the main shaft comprises a first shaft body and a second shaft body, wherein
the first shaft body and the second shaft body enclose first arc-shaped space and second arc-shaped space;
the first end of the first rotating member has a first arc-shaped arm, the first arc-shaped arm is located in the first arc-shaped space, and the first end of the first rotating member is rotatably connected to the main shaft through the first arc-shaped arm and the first arc-shaped space; and
the first end of the second rotating member has a second arc-shaped arm, the second arc-shaped arm is located in the second arc-shaped space, and the first end of the second rotating member is rotatably connected to the main shaft through the second arc-shaped arm and the second arc-shaped space.

11. The foldable electronic device according to claim 10, wherein
in processes of folding and unfolding the foldable electronic device, the first arc-shaped arm rotates along the first arc-shaped space, and the second arc-shaped arm rotates along the second arc-shaped space.

12. The foldable electronic device according to claim 10 or 11, wherein
in the process of folding the foldable electronic device, the first arc-shaped arm rotates out of the first arc-shaped space, and the second arc-shaped arm rotates out of the second arc-shaped space; and
in the process of unfolding the foldable electronic device, the first arc-shaped arm rotates into the first arc-shaped space, and the second arc-shaped arm rotates into the second arc-shaped space.

13. The foldable electronic device according to any one of claims 1 to 12, wherein the first body has a first sliding groove, the first rotating member has a first sliding end, the first sliding end is disposed in the first sliding groove, and the first rotating member is slidably connected to the first body through the first sliding groove and the first sliding end; and
the second body has a second sliding groove, the second rotating member has a second sliding end, the second sliding end is disposed in the second sliding groove, and the second rotating member is slidably connected to the second body through the second sliding groove and the second sliding end.

14. The foldable electronic device according to claim 13, wherein in the process of folding the foldable electronic device, the first sliding end slides into the first sliding groove, and the second sliding end slides into the second sliding groove; and
in the process of unfolding the foldable electronic device, the first sliding end slides out of the first sliding groove, and the second sliding end slides out of the second sliding groove.

15. The foldable electronic device according to any one of claims 1 to 14, wherein the first foldable assembly further comprises a first suspension assembly;
the first rotating member has a first mounting groove, and the first suspension assembly is disposed in the first mounting groove;
the first suspension assembly is in sliding contact with the first body, and is configured to provide a damping force when the first rotating member slides relative to the first body;
the second foldable assembly further comprises a second suspension assembly;
the second rotating member has a second mounting groove, and the second suspension assembly is disposed in the second mounting groove; and
the second suspension assembly is in sliding contact with the second body, and is configured to provide a damping force when the second rotating member slides relative to the second body.

16. The foldable electronic device according to any one of claims 1 to 15, wherein the hinge further comprises a cover assembly, and the cover assembly comprises a first plate body, a second plate body, and a third plate body, wherein
the first plate body is fastened to the first rotating member, the second plate body is fastened to the second rotating member, and the third plate body is fastened to the main shaft.

17. The foldable electronic device according to any one of claims 1 to 16, further comprising a synchronization assembly, wherein the synchronization assembly is in transmission connection to the first body, the main shaft, and the second body for the first foldable assembly and the second foldable assembly to synchronously and reversely rotate.

18. The foldable electronic device according to claim 17, wherein the synchronization assembly comprises a first synchronization member and a second synchronization member, wherein
the first synchronization member is rotatably connected to the main shaft, and a rotation axis center of the first synchronization member coincides with a rotation axis center of the first rotating member; and the second synchronization member is rotatably connected to the main shaft, and a rotation axis center of the second synchronization member coincides with a rotation axis center of the second rotating member, wherein
the first synchronization member has a first tooth-shaped part and a first sliding part, and the second synchronization member has a second tooth-shaped part and a second sliding part; and
the first tooth-shaped part is engaged with the second tooth-shaped part, the first sliding part is slidably connected to the first body, and the second sliding part is slidably connected to the second body.

19. The foldable electronic device according to any one of claims 1 to 18, wherein the hinge comprises a plurality of first foldable assemblies and second foldable assemblies, wherein
the plurality of first foldable assemblies and the plurality of second foldable assemblies are disposed in a direction parallel to a length direction of the main shaft.

20. A hinge used in a foldable electronic device, wherein the foldable electronic device comprises a flexible display, and the hinge comprises a main shaft, a first foldable assembly, and a second foldable assembly, wherein the first foldable assembly and the second foldable assembly are disposed on two sides of the main shaft, wherein
the first foldable assembly comprises a first rotating member, a first body, and a first connecting rod;
a first end of the first rotating member is rotatably connected to the main shaft, and a second end of the first rotating member is slidably connected to the first body;
the second foldable assembly comprises a second rotating member, a second body, and a second connecting rod;
a first end of the second rotating member is rotatably connected to the main shaft, and a second end of the second rotating member is slidably connected to the second body;
a first end of the first connecting rod is rotatably connected to the first body, and a second end of the first connecting rod is rotatably connected to the first end of the second rotating member; and
a first end of the second connecting rod is rotatably connected to the second body, and a second end of the second connecting rod is rotatably connected to the second end of the first rotating member, wherein
the first body has a first support surface for supporting the flexible display, the second body has a second support surface for supporting the flexible display, and when the hinge is in an unfolded state, the first support surface and the second support surface are located on a same plane.

21. The hinge according to claim 20, wherein the main shaft has a third support surface for supporting the flexible display, and when the hinge is in the unfolded state, the first mounting surface, the first support surface, the third support surface, the second support surface, and the second mounting surface are sequentially spliced to form a support surface for supporting the flexible display.

22. The hinge according to claim 21, wherein the flexible display is fastened on the third support surface, or the flexible display is lapped on the third support surface.

23. The hinge according to claim 21 or 22, wherein the third support surface is a flat surface or a curved surface.

24. The hinge according to claim 21 or 22, wherein a side that is of the third support surface and that is adjacent to the first support surface is a first curved surface, a side that is of the third support surface and that is adjacent to the second support surface is a second curved surface, and a flat surface is disposed between the first curved surface and the second curved surface.

25. The hinge according to any one of claims 20 to 24, wherein the first rotating member and the first connecting rod are both located on a side that is of the first body and that is opposite to the first support surface; and
the second rotating member and the second connecting rod are both located on a side that is of the first body and that is opposite to the second support surface.

26. The hinge according to any one of claims 20 to 25, wherein the second end of the first connecting rod has a first pin hole, the first end of the second rotating member has a second pin hole, and the first connecting rod is rotatably connected to the second rotating member via a pin shaft that penetrates the first pin hole and the second pin hole; and
the second end of the second connecting rod has a third pin hole, the first end of the first rotating member has a fourth pin hole, and the second connecting rod is rotatably connected to the first rotating member via a pin shaft that penetrates the third pin hole and the fourth pin hole.

27. The hinge according to any one of claims 20 to 26, wherein when the first foldable assembly and the second foldable assembly rotate toward each other, the first mounting surface and the second mounting surface tend to be away from each other; and
the second body approaches the main shaft, and the first body approaches the main shaft.

28. The hinge according to any one of claims 20 to 27, wherein when the first foldable assembly and the second foldable assembly rotate away from each other,
the second body moves away from the main shaft, and the first body moves away from the main shaft.

29. The hinge according to any one of claims 20 to 28, wherein the main shaft comprises a first shaft body and a second shaft body, wherein
the first shaft body and the second shaft body enclose first arc-shaped space and second arc-shaped space;
the first end of the first rotating member has a first arc-shaped arm, the first arc-shaped arm is located in the first arc-shaped space, and the first end of the first rotating member is rotatably connected to the main shaft through the first arc-shaped arm and the first arc-shaped space; and
the first end of the second rotating member has a second arc-shaped arm, the second arc-shaped arm is located in the second arc-shaped space, and the first end of the second rotating member is rotatably connected to the main shaft through the second arc-shaped arm and the second arc-shaped space.

30. The hinge according to claim 29, wherein
in processes of folding and unfolding the foldable electronic device, the first arc-shaped arm rotates along the first arc-shaped space, and the second arc-shaped arm rotates along the second arc-shaped space.

31. The hinge according to claim 29 or 30, wherein
in the process of folding the foldable electronic device, the first arc-shaped arm rotates out of the first arc-shaped space, and the second arc-shaped arm rotates out of the second arc-shaped space; and
in the process of unfolding the foldable electronic device, the first arc-shaped arm rotates into the first arc-shaped space, and the second arc-shaped arm rotates into the second arc-shaped space.

32. The hinge according to any one of claims 20 to 31, wherein the first body has a first sliding groove, the first rotating member has a first sliding end, the first sliding end is disposed in the first sliding groove, and the first rotating member is slidably connected to the first body through the first sliding groove and the first sliding end; and
the second body has a second sliding groove, the second rotating member has a second sliding end, the second sliding end is disposed in the second sliding groove, and the second rotating member is slidably connected to the second body through the second sliding groove and the second sliding end.

33. The hinge according to claim 32, wherein in the process of folding the foldable electronic device, the first sliding end slides into the first sliding groove, and the second sliding end slides into the second sliding groove; and
in the process of unfolding the foldable electronic device, the first sliding end slides out of the first sliding groove, and the second sliding end slides out of the second sliding groove.

34. The hinge according to any one of claims 20 to 33, wherein the first foldable assembly further comprises a first suspension assembly;
the first rotating member has a first mounting groove, and the first suspension assembly is disposed in the first mounting groove;
the first suspension assembly is in sliding contact with the first body, and is configured to provide a damping force when the first rotating member slides relative to the first body;
the second foldable assembly further comprises a second suspension assembly;
the second rotating member has a second mounting groove, and the second suspension assembly is disposed in the second mounting groove; and
the second suspension assembly is in sliding contact with the second body, and is configured to provide a damping force when the second rotating member slides relative to the second body.

35. The hinge according to any one of claims 20 to 34, wherein the hinge further comprises a cover assembly, and the cover assembly comprises a first plate body, a second plate body, and a third plate body, wherein
the first plate body is fastened to the first rotating member, the second plate body is fastened to the second rotating member, and the third plate body is fastened to the main shaft.

36. The hinge according to any one of claims 20 to 35, further comprising a synchronization assembly, wherein the synchronization assembly is in transmission connection to the first body, the main shaft, and the second body for the first foldable assembly and the second foldable assembly to synchronously and reversely rotate.

37. The hinge according to claim 36, wherein the synchronization assembly comprises a first synchronization member and a second synchronization member, wherein
the first synchronization member is rotatably connected to the main shaft, and a rotation axis center of the first synchronization member coincides with a rotation axis center of the first rotating member; and the second synchronization member is rotatably connected to the main shaft, and a rotation axis center of the second synchronization member coincides with a rotation axis center of the second rotating member, wherein
the first synchronization member has a first tooth-shaped part and a first sliding part, and the second synchronization member has a second tooth-shaped part and a second sliding part; and
the first tooth-shaped part is engaged with the second tooth-shaped part, the first sliding part is slidably connected to the first body, and the second sliding part is slidably connected to the second body.

38. The hinge according to any one of claims 20 to 37, wherein the hinge comprises a plurality of first foldable assemblies and second foldable assemblies, wherein
the plurality of first foldable assemblies and the plurality of second foldable assemblies are disposed in a direction parallel to a length direction of the main shaft.
